# EUROPÄISCHE PATENTSCHRIFT

(11) **EP 0 974 250 B1**
(45) Veröffentlichungstag und Bekanntmachung des Hinweises auf die Patenterteilung: **06.03.2002**
(21) Anmeldenummer: 98966332.3
(22) Anmeldetag: 15.12.1998
(51) Int. Cl.: H05K 5/00

(54) **GEHÄUSE MIT STECKER**
HOUSING WITH A PLUG CONNECTOR
BOITIER MUNI D'UN CONNECTEUR

(30) Priorität: 14.01.1998 DE 19801006
(43) Veröffentlichungstag der Anmeldung: 26.01.2000
(73) Patentinhaber: Conti Temic microelectronic GmbH, 90411 Nürnberg (DE)
(72) Erfinder: BAUR, Richard, D-85276 Pfaffenhofen (DE); FENDT, Günter, D-86529 Schrobenhausen (DE)
(74) Vertreter: Kolb, Georg
(86) Internationale Anmeldenummer: EP9808211
(87) Internationale Veröffentlichungsnummer: WO9937127

(56) Entgegenhaltungen:
- EP-A- 0 712 265

## Beschreibung

Die Erfindung betrifft ein Gehäuse mit Stecker zur Aufnahme von elektronischen Bauelementen nach dem Oberbegriff des Patentanspruchs 1. Siehe z.B. das Dokument EP-A-0 712 265.

insbesondere in Fahrzeugen werden zunehmend Kunststoffgehäuse mit integrierten Steckern (als Gegenstück einer anzuschließenden Buchse) verwendet, um Sensoren, Steuerungen und andere elektrotechnische Komponenten darin unterzubringen und mit anderen elektrotechnischen Geräten oder Komponenten zu verbinden. Oftmals wird zur Kostenreduzierung bei einem bestimmten Fahrzeugtyp für einen speziellen Zweck, beispielsweise zur Unterbringung der Auslöseelektronik des Insassenschutzsystems, nur eine Art von Gehäuse verwendet. Jedoch kann sich auch beim gleichen Fahrzeugtyp aufgrund von konstruktiven unterschieden von Modell zu Modell die in identischen Gehäusen untergebrachte Steuerung anhand ihres Parametersatzes unterscheiden. Häufig werden auch in Testläufen Steuerungen mit unterschiedlichen Parametersätze laufend ausgetauscht und miteinander verglichen, um die optimale Einstellung herauszufinden.

Das bedeutet, daß optisch identischen Gehäusen nicht ohne weiteres anzusehen ist, auf welchen Parametersatz die darin untergebrachte Steuerung oder Schaltung eingestellt ist. Die demzufolge bestehende Gefahr der Verwechslung kann dazu führen, daß in ein bestimmtes Modell eine Steuerung mit falschem Parametersatz eingebaut und das Insassenschutzsystem daher im Fall einer Auslösung nicht zum optimalen Zeitpunkt ausgelöst wird.

Es ist deshalb Aufgabe der Erfindung, eine einfache Anordnung zur Kennzeichnung für ein Gehäuse mit Stecker anzugeben, das die genannten Nachteile vermeidet und die Gefahr der Verwechslung merklich verringert.

Diese Aufgabe wird durch die Merkmale des Anspruchs 1 gelöst, wonach ein Gehäuse mit Stecker zur Aufnahme von elektronischen Bauelementen dadurch gekennzeichnet ist, daß der Stecker im Bereich seines Steckerschachtes wenigstens eine Markierung und das Gehäuse im Bereich der Markierung wenigstens eine Aussparung aufweist.

Die Vorteile der Erfindung liegen darin, daß bei der Montage oder im Fall eines Austausches problemlos auf optischem Wege diejenige Schaltung, die den zugehörigen Parametersatz aufweist, erkannt wird, auch wenn eine Steckerbuchse in den Stecker eingesteckt ist.

Vorteilhafte Weiterbildungen der Erfindung sind in den Unteransprüchen beschrieben.

Ein Ausführungsbeispiel der Erfindung ist nachstehend ausführlich erläutert und anhand der Figuren dargestellt.

Es zeigen
- Fig. 1:: eine schnittbildliche Darstellung einer in ein Gehäuse integrierten und gekennzeichnetem Stecker und
- Fig. 2:: eine Draufsicht auf einen Teil des Gehäuses nach Fig. 1.

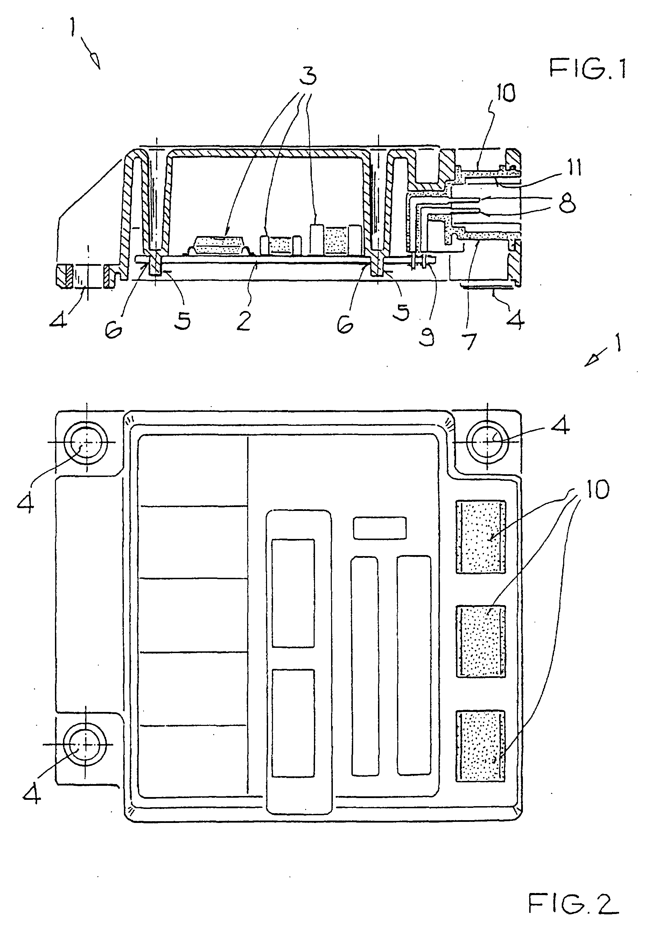

Die **Fig. 1** zeigt ein vorzugsweise aus thermoplastischem Kunststoff bestehendes Gehäuse **1**, in dem auf einer Leiterplatte **2** eine elektronische Schaltung mit elektrotechnischen Bauelementen **3** untergebracht ist, wobei es sich beispielsweise um eine Steuerung für ein Insassenschutzsystem handelt. Zur Befestigung, beispielsweise an der Karosserie eines Fahrzeugs, weist das Gehäuse **1** angeformte Befestigungsösen **4** auf. Das Gehäuse **1** weist zudem angeformte Stützen **5** und die Leiterplatte **2** Aussparungen **6** auf, womit die Leiterplatte **2** in das Gehäuse **1** eingepaßt ist.

Ferner weist das Gehäuse **1** einen Stecker **7** mit Steckerschacht **11** und Stekkerpins **8** auf, mittels dem die im Gehäuse **1** untergebrachte Schaltung mit der Spannungsversorgung des Fahrzeugs und anderen Komponenten elektrisch verbunden wird. Beim Stecker **7** handelt es sich vorzugsweise um ein Einlege-, Einpreß- oder Einrastteil aus Kunststoff, das vorgefertigt ist und bei der Herstellung mit dem Kunststoff, aus dem das Gehäuse **1** besteht, umspritzt wird. Die Steckerpins **8** sind an ihrer der Leiterplatte **2** zugewandten Spitze als Einpreßstifte oder Federstifte ausgebildet und bilden mit auf der Leiterplatte **2** angeordneten Kontaktstellen **9** einen elektrischen Kontakt.

Da die aus den Bauelementen **3** bestehende Schaltung mit mehreren verschiedenen Parametern, sogenannten Parametersätzen, eingestellt sein kann, ist es zur Vermeidung von Verwechslungen sinnvoll, jedem einzelnen Parametersatz einen eigenen und im Bereich seines Steckerschachtes **11** besonders gekennzeichneten Stecker **7** zuzuweisen. Diese Kennzeichnung kann beispielsweise dadurch vorgenommen werden, daß in den Steckerschacht **11** numerische oder alphanumerische Zeichen eingeprägt bzw. diese auf den Steckerschacht **11** aufgeprägt sind. Sie kann auch darin bestehen, daß jeder Steckerschacht **11** aus einem eingefärbten Kunststoff hergestellt ist, wobei jede Farbe zu einem bestimmten Parametersatz gehört.

Das Gehäuse **1** weist Aussparungen **10** auf, damit die Kennzeichnung auf dem Steckerschacht **11** auch bei einer in den Stecker **7** eingesteckten Stekkerbuchse von außen sichtbar bleibt, so daß bei der Montage oder bei einem Austausch nicht versehentlich eine Schaltung mit einem falschen Parametersatz ins Fahrzeug eingebaut wird.

in **Fig**. **2** ist das Gehäuse **1** mit den Befestigungsösen **4** aus der Sicht von oben dargestellt. Aufgrund der Aussparungen **10** kann jederzeit die farbliche, numerische, alphanumerische oder sonstige Kennzeichnung auf dem Steckerschacht **11** des in das Gehäuse eingelegten Steckers **7** (Fig. 1) erkannt werden, die auf eine mit einem bestimmten Parametersatz eingestellte elektronische Schaltung hinweist.

Die erfindungsgemäße Anordnung zur Kennzeichnung für ein Gehäuse mit Stecker ist für solche Gehäuse geeignet, die ein identisches Aussehen besitzen, deren Inhalt aber von Fall zu Fall unterschiedlich und von außen normalerweise nicht sichtbar ist.

## Patentansprüche

1. Gehäuse (1) mit Stecker (7) zur Aufnahme von elektronischen Bauelementen, **dadurch gekennzeichnet, daß** der Stecker (7) im Bereich seines Stekkerschachtes (11) wenigstens eine Markierung und das Gehäuse (1) im Bereich der Markierung wenigstens eine Aussparung (10) aufweist.

2. Anordnung nach Anspruch 1, **dadurch gekennzeichnet, daß** der Stecker (7) als Einlege-, Einpreß- oder Einrastteil ausgebildet und aus Kunststoff hergestellt ist.

3. Anordnung nach Anspruch 1, **dadurch gekennzeichnet, daß** es sich bei der Markierung um eine farbliche Kodierung handelt.

4. Anordnung nach Anspruch 1, **dadurch gekennzeichnet, daß** es sich bei der Markierung um eine numerische oder alphanumerische Kodierung handelt.

5. Anordnung nach Anspruch 1, **dadurch gekennzeichnet, daß** das Gehäuses (1) aus einem thermoplastischen Kunststoff hergestellt ist.

## Claims

1. A housing (1) incorporating a connector plug (7) for accommodating electronic components, **characterised in that** the connector plug (7) comprises at least one marking in the region of its plug shaft (11), and the housing (1) comprises at least one recess (10) in the region of the marking.

2. An arrangement in accordance with Claim 1, **characterised in that** the connector plug (7) is made of synthetic material and is in the form of an insertion, a push-in or an interlocking member.

3. An arrangement in accordance with Claim 1, **characterised in that** the marking is a coloured encoding.

4. An arrangement in accordance with Claim 1, **characterised in that** the marking is a numeric or alphanumeric encoding.

5. An arrangement in accordance with Claim 1, **characterised in that** the housing (1) is made of a thermoplastic synthetic material.

## Revendications

1. Boîtier (1) comportant un connecteur (7) pour recevoir des composants électroniques, **caractérisé en ce que** le connecteur (7) comporte, dans la zone de son conduit (11), au moins une marque, et le boîtier (1) comporte, dans la zone de la marque, au moins un évidement (10).

2. Dispositif selon la revendication 1, **caractérisé en ce que** le connecteur (7) est agencé sous la forme d'une pièce d'insertion, d'enfoncement ou d'encliquetage et est réalisé en matière plastique.

3. Dispositif selon la revendication 1, caractérisé qu'en ce qui concerne la marque, il s'agit d'un codage coloré.

4. Dispositif selon la revendication 1, caractérisé qu'en ce qui concerne la marque, il s'agit d'un codage numérique ou alphanumérique.

5. Dispositif selon la revendication 1, **caractérisé en ce que** le boîtier (1) est réalisé en une matière thermoplastique
